# EUROPEAN PATENT APPLICATION

(11) **EP 4 852 668 A1**
(43) Date of publication of application: **09.12.2026**
(21) Application number: 25191679.7
(22) Date of filing: 24.07.2025
(51) Int. Cl.: H10F 77/20

(54) **BACK CONTACT SOLAR CELL, BACK CONTACT TANDEM SOLAR CELL AND PHOTOVOLTAIC MODULE**

(30) Priority: 03.06.2025 CN 202510727112; 04.06.2025 CN 202510742940
(71) Applicant: Jinko Solar (Haining) Co., Ltd., Haining City, Zhejiang 314415 (CN)
(72) Inventor: WANG, Luchuang, Haining, Zhejiang 314415 (CN); PENG, Yingying, Haining, Zhejiang 314415 (CN); FANG, Sheng, Haining, Zhejiang 314415 (CN)
(74) Representative: Algemeen Octrooi- en Merkenbureau B.V.

(57) **Abstract**

Back contact solar cell, back contact tandem solar cell and photovoltaic module, back contact solar cell includes: cell substrate having two edge regions opposite along first direction, two border regions opposite along second direction and central region; first and second fingers located on cell substrate; soldering pads located in border region; edge connecting line at least located at edge region, edge connecting line and soldering pad closest to edge connecting line being electrically connected to same-polarity electrode; first connecting portion electrically connected to edge connecting line and soldering pad closest to edge connecting line; and second connecting portion electrically connected to opposite-polarity electrode disconnected by soldering pad; edge connecting line includes two thickened portions and body portion located between two thickened portions, and thickened portions are electrically connected to same-polarity electrode located in border region and same-polarity electrode located in central region and disconnected by second connecting portion.

## Description

### TECHNICAL FIELD

The present disclosure relates to the field of photovoltaics and, in particular, to a back contact solar cell, a back contact tandem solar cell and a photovoltaic module.

### BACKGROUND

With gradual depletion of fossil energy, photovoltaic cells are more and more widely used as a new energy alternative. The photovoltaic cell is a device for converting solar energy into electric energy. The photovoltaic cell generates carriers by utilizing a photovoltaic principle, and then, the carriers are led out by using an electrode, thereby facilitating effective utilization of the electric energy. The electrode of the photovoltaic cell has the important function of collecting and transporting electrons. When a photovoltaic module is obtained by assembling a plurality of photovoltaic cells, a soldering pad and/or a soldering joint is usually arranged on the electrode, and then, a solder strip is used to electrically contact the soldering pad and/or the soldering joint, so as to electrically connect the electrodes of the adjacent photovoltaic cells.

In order to further avoid shielding of a front surface of the photovoltaic cell by the electrode, research on an interdigitated back contact (IBC) solar cell, i.e., a back contact solar cell, is deeper and deeper.

However, in the IBC solar cell, in order to improve the carrier collection efficiency, as an electrical connection relationship between the plurality of electrodes and the soldering pads and/or the soldering joints changes, the current densities collected in different regions in the back contact solar cell may have a large difference, which affects the overall electrical performance of the back contact solar cell (for example, a hot spot effect is easily generated in a local region), thus reducing the photoelectric conversion efficiency of the back contact solar cell.

### SUMMARY

Embodiments of the present disclosure provide a back contact solar cell, a back contact tandem solar cell and a photovoltaic module, which are at least beneficial to improving the electrical performance of the back contact solar cell.

In an aspect, some embodiments of the present disclosure provide a back contact solar cell, including: a cell substrate having two edge regions opposite to each other along a first direction, two border regions opposite to each other along a second direction and a central region located between the two border regions; first fingers and second fingers located on the cell substrate and alternately arranged along the second direction; soldering pads located in the border region, each soldering pad being electrically connected to at least one same-polarity electrode; an edge connecting line at least located at the edge region, the edge connecting line and the soldering pad closest to the edge connecting line being electrically connected to the same-polarity electrode; a first connecting portion extending in the first direction and electrically connected to the edge connecting line and the soldering pad closest to the edge connecting line; at least one opposite-polarity electrode located on a side of the first connecting portion close to the central region and disconnected by the soldering pad; and a second connecting portion extending along the second direction and electrically connected to the opposite-polarity electrode disconnected by the soldering pad, at least one same-polarity electrode being disconnected by the second connecting portion; wherein the edge connecting line includes two thickened portions opposite along the second direction and a body portion located between the two thickened portions, and the thickened portions are electrically connected to the same-polarity electrode located in the border region as well as the same-polarity electrode located in the central region and disconnected by the second connecting portion; in the first direction, a width of the thickened portion is greater than a width of the body portion; one of the first finger and the second finger is the same-polarity electrode, and the other is the opposite-polarity electrode.

In some embodiments, the back contact solar cell further includes: a first auxiliary line electrically connected to the soldering pad as well as at least one same-polarity electrode located on a side of the soldering pad away from the central region; and a second auxiliary line electrically connected to the soldering pad as well as at least one same-polarity electrode located on a side of the soldering pad close to the central region.

In some embodiments, a width of the first auxiliary line is greater than that of the second auxiliary line along the first direction.

In some embodiments, the cell substrate has first soldering regions and second soldering regions located between the two edge regions and alternately arranged in the first direction; the back contact solar cell further includes: a plurality of soldering joints arranged between two adjacent soldering pads at intervals along the second direction, one first finger located on a region where the first soldering region and the central region coincide is electrically connected to one soldering joint, and one second finger located on a region where the second soldering region and the central region coincide is electrically connected to one soldering joint.

In some embodiments, along the second direction, one second finger is arranged between two adjacent soldering joints located in the same first soldering region; and along the second direction, one first finger is arranged between two adjacent soldering joints located in the same second soldering region.

In some embodiments, a width of the first connecting portion is greater than that of the same-polarity electrode along the second direction.

In some embodiments, at least one opposite-polarity electrode on a side of the first connecting portion away from the central region is disconnected by the soldering pad; the back contact solar cell further includes: a third connecting portion extending along the second direction and electrically connected to the opposite-polarity electrode disconnected by the soldering pad and located on the side of the first connecting portion away from the central region, at least one same-polarity electrode being disconnected by the third connecting portion.

In some embodiments, the cell substrate has a plurality of soldering regions located between the two edge regions and spaced apart along the first direction; the back contact solar cell further includes: a bus portion located on an overlapped region of some soldering regions and the border region, the bus portion is electrically connected to a plurality of same-polarity electrodes located on the side of the soldering pad away from the central region, and the soldering region with the bus portion is spaced apart from the edge region by at least one soldering region.

In some embodiments, the edge connecting line further includes: a border portion located in the border region and extending along the second direction, one end of the border portion is electrically connected to one end of the thickened portion, and the body portion is electrically connected to the other end of the thickened portion; the border portion is in contact connection with the bus portion electrically connected to one of the first finger and the second finger, and is disconnected at the bus portion electrically connected to the other of the first finger and the second finger.

In another aspect, some embodiments of the present disclosure further provide a back contact tandem solar cell, including: a bottom cell which is the back contact solar cell according to any one of the above descriptions; and a top cell located on a side of the bottom cell.

In yet another aspect, some embodiments of the present disclosure further provide a photovoltaic module, including: a solar cell string formed by connecting a plurality of back contact solar cells according to any one of the above descriptions or by connecting a plurality of back contact tandem solar cells according to any one of the above descriptions; a encapsulation adhesive film for covering a surface of the solar cell string; and a cover plate for covering a surface of the encapsulation adhesive film away from the solar cell string.

The technical solution of the embodiments of the present disclosure at least has the following advantages.

First, the edge connecting line and the soldering pad closest to the edge connecting line are electrically connected to the same-polarity electrode, so that even if a part of the same-polarity electrode directly facing a solder strip has a poor electrical connection, carriers in a part of the same-polarity electrode close to the edge region can be collected through the edge connecting line, the first connecting portion and the soldering pad, thereby facilitating an improvement of the collection efficiency of the carriers in the back contact solar cell. In addition, the edge connecting line can increase circulation paths of the carriers in the same-polarity electrode, and promote uniform circulation of the current in the back contact solar cell to improve the overall electrical performance of the back contact solar cell, such as current density homogenization, thereby improving the hot spot resistance of the back contact solar cell.

Further, the thickened portion of the edge connecting line is designed to be electrically connected to the same-polarity electrode located in the border region as well as the same-polarity electrode located in the central region and disconnected by the second connecting portion. In other words, the thickened portion of the edge connecting line not only extends to a part connected to the first connecting portion, but also further extends close to the central region. Therefore, on the basis of improving the transport efficiency of the carriers in the thickened portion by means of the larger width of the thickened portion in the first direction, by means of the thickened portion directly facing at least a partial region of the first connecting portion in the first direction, the efficiency of collecting, by the edge connecting line, the carriers in the same-polarity electrode disconnected by the second connecting portion is favorably improved, for example, the loss of the carriers in the same-polarity electrode disconnected by the second connecting portion is reduced in the process that the carriers are transported to the solder strip by means of the edge connecting line, the first connecting portion and the soldering pad, thereby facilitating a reduction of the difference between the density of the carriers in the same-polarity electrode disconnected by the second connecting portion and the density of the carriers in the same-polarity electrodes in other regions, so as to further promote uniform circulation of the current in the back contact solar cell, and therefore further improve the overall electrical performance of the back contact solar cell.

### BRIEF DESCRIPTION OF DRAWINGS

One or more embodiments are illustrated by corresponding figures in the drawings, these illustrations do not constitute limitations on the embodiments, and unless stated otherwise, the figures in the drawings do not constitute a scale limitation. To better describe the technical solutions in the embodiments of the present disclosure or the related art, the following briefly describes the accompanying drawings required for the embodiments. Apparently, the accompanying drawings in the following description show merely some embodiments of the present disclosure, and a person of ordinary skill in the art may still derive other drawings from these accompanying drawings without creative efforts.
FIG. 1 is a first schematic partial enlarged top diagram of a back contact solar cell according to one or more embodiments of the present disclosure;
FIG. 2 is a second schematic partial enlarged top diagram of the back contact solar cell according to one or more embodiments of the present disclosure;
FIG. 3 is a third schematic partial enlarged top diagram of the back contact solar cell according to one or more embodiments of the present disclosure;
FIG. 4 is a fourth schematic partial enlarged top diagram of the back contact solar cell according to one or more embodiments of the present disclosure;
FIG. 5 is a schematic enlarged top diagram of the back contact solar cell according to one or more embodiments of the present disclosure;
FIG. 6 is another schematic enlarged top diagram of the back contact solar cell according to one or more embodiments of the present disclosure;
FIG. 7 is a schematic top diagram of a combination of a soldering pad and a bus portion in the back contact solar cell according to one or more embodiments of the present disclosure;
FIG. 8 is a schematic partial sectional diagram of a back contact tandem solar cell according to one or more embodiments of the present disclosure;
FIG. 9 is a schematic partial perspective diagram of a solar cell string in a photovoltaic module according to one or more embodiments of the present disclosure; and
FIG. 10 is a schematic partial sectional diagram of the photovoltaic module according to one or more embodiments of the present disclosure.

Reference signs:
100: cell substrate; 110: edge region; 120: border region; 130: central region; 45: soldering region; 140: first soldering region; 150: second soldering region; 101: first finger; 102: second finger; 103: soldering pad; 104: edge connecting line; 114: thickened portion; 124: body portion; 134: border portion; 105: first connecting portion; 106: second connecting portion; 117: first auxiliary line; 127: second auxiliary line; 109: third connecting portion; 119: bus portion; 129: bottom cell; 139: top cell; 40: photovoltaic cell; 41: encapsulation adhesive film; 42: cover plate; 43: conductive strip.

### DESCRIPTION OF EMBODIMENTS

As is known from the BACKGROUND, the electrical performance of the back contact solar cell needs to be improved.

Embodiments of the present disclosure provide a back contact solar cell, a back contact tandem solar cell and a photovoltaic module. In the back contact solar cell, an edge connecting line and a soldering pad closest to the edge connecting line are electrically connected to a same-polarity electrode, so that even if a part of the same-polarity electrode directly facing a solder strip has a poor electrical connection, carriers in a part of the same-polarity electrode close to an edge region can be collected through the edge connecting line, a first connecting portion and the soldering pad, thereby facilitating an improvement of the collection efficiency of the carriers in the back contact solar cell. In addition, the edge connecting line can increase circulation paths of the carriers in the same-polarity electrode, and promote uniform circulation of the current in the back contact solar cell to improve the overall electrical performance of the back contact solar cell, such as current density homogenization, thereby improving the hot spot resistance of the back contact solar cell. Further, a thickened portion of the edge connecting line is designed to be electrically connected to the same-polarity electrode located in a border region as well as the same-polarity electrode located in a central region and disconnected by a second connecting portion. In other words, the thickened portion of the edge connecting line not only extends to a part connected to the first connecting portion, but also further extends close to the central region. Therefore, on the basis of improving the transport efficiency of the carriers in the thickened portion by means of the larger width of the thickened portion in a first direction, by means of the thickened portion directly facing at least a partial region of the first connecting portion in the first direction, the efficiency of collecting, by the edge connecting line, the carriers in the same-polarity electrode disconnected by the second connecting portion is favorably improved, for example, the loss of the carriers in the same-polarity electrode disconnected by the second connecting portion is reduced in the process that the carriers are transported to the solder strip by means of the edge connecting line, the first connecting portion and the soldering pad, thereby facilitating a reduction of the difference between the density of the carriers in the same-polarity electrode disconnected by the second connecting portion and the density of the carriers in the same-polarity electrodes in other regions, so as to further promote uniform circulation of the current in the back contact solar cell, and therefore further improve the overall electrical performance of the back contact solar cell.

In the description of embodiments of the present disclosure, technical terms "first", "second" and the like are intended only to distinguish different objects, which shall not be construed as indicating or implying a relative importance, or implicitly specifying the number, a particular order or primary and secondary relations of the indicated technical features. In the description of embodiments of the present disclosure, "a plurality of" means two or more, unless specifically stated otherwise.

The "embodiments" mentioned herein means that particular features, structures or characteristics described with reference to the embodiments may be included in one or more embodiments of the present disclosure. Phrases appearing at various positions of the specification neither always refer to the same embodiments, nor separate or alternative embodiments that are mutually exclusive with other embodiments. It is explicitly and implicitly understood by those skilled in the art that the embodiments described herein may be combined with other embodiments.

In the description of embodiments of the present disclosure, the term "and/or" is merely an association relationship describing associated objects, indicating that three relationships may exist. For example, A and/or B indicates that there are three cases of A, A and B together, and B. In addition, the character "/" herein generally means that associated objects before and after "/"are in an "or" relationship.

In the description of embodiments of the present disclosure, the term "a plurality of" means two or more. Similarly, "a plurality of groups" means two or more groups, and "a plurality of pieces" means two or more pieces.

In the description of embodiments of the present disclosure, the orientation or position relationship indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are only intended to facilitate the description of embodiments of the present disclosure and simplify the description, rather than indicating or implying that the device or element referred to must have a particular orientation or be constructed and operated in a particular orientation, and therefore are not to be interpreted as limitations on the embodiments of the present disclosure.

In the description of embodiments of the present disclosure, unless specifically stated and limited, the technical terms "mounting," "coupling", "connecting" and "fixing" should be understood in a broad sense, such as, a fixed connection, a detachable connection, or an integral connection; a mechanical connection or an electrical connection; a direct connection, an indirect connection through an intermediate medium, an internal connection of two elements, or an interaction of two elements. For those of ordinary skill in the art, the specific meanings of the above terms in embodiments of the present disclosure can be understood on case-by-case.

In the drawings corresponding to embodiments of the present disclosure, the thicknesses and areas of layers are exaggerated for better understanding and ease of description. When a component (e.g., layer, film, region, or base) is described as being on another component or on a surface thereof, it can be "directly" on the surface of the other component or a third component can be present between the two components. Conversely, when a component is described as being on a surface of another component or a surface of a component is described as being formed or provided with another component, there is no third component between the two components. Furthermore, when a component is described as being formed "substantially" on another component, the component is not formed on the entire surface (or front surface) of the other component, nor on a partial edge of the entire surface.

In the description of embodiments of the present disclosure, when a component "includes" another component, other components are not excluded unless otherwise stated, and the other components may be further included. Furthermore, when a layer, film, region, plate, or the like, is referred to as being "on/located on" another component, it can be "directly on" the other component (i.e., on a surface of the other component without other components therebetween) or another component is present therebetween. Furthermore, when a layer, film, region, plate, or the like, is "directly on" another component, or when a layer, film, region, plate, or the like, is on a surface of another component, no other component is located therebetween.

The terminology used in the description of various described embodiments herein is for the purpose of describing particular embodiments only and is not intended to be limiting. As used in the description of the various described embodiments and the appended claims, the "component" is also intended to include the plural form unless the context clearly indicates otherwise. The component includes a layer, a film, a region, a plate, or the like.

Embodiments of the present disclosure will be described in detail below with reference to the accompanying drawings. However, it may be appreciated by those of ordinary skill in the art that in the embodiments of the present disclosure, numerous technical details are set forth in order to enable a reader to better understand of the embodiments of the present disclosure. However, it is possible to implement the technical solution claimed by the embodiments of the present disclosure without these technical details and variations and modifications based on the following embodiments.

One or more embodiments of the present disclosure provide a back contact solar cell, which will be described in detail below with reference to the accompanying drawings.

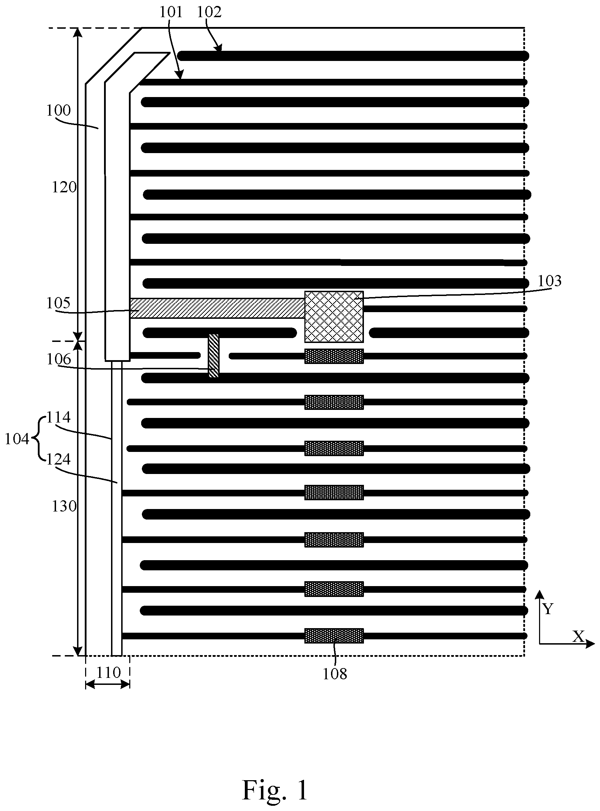

Referring to FIG. 1 to FIG. 6, the back contact solar cell includes: a cell substrate 100 having two edge regions 110 opposite to each other along a first direction X, two border regions 120 opposite to each other along a second direction Y and a central region 130 located between the two border regions 120; first fingers 101 and second fingers 102 located on the cell substrate 100 and alternately arranged along the second direction Y; soldering pads 103 located in the border region 120, each soldering pad 103 being electrically connected to at least one same-polarity electrode; an edge connecting line 104 at least located at the edge region 110, the edge connecting line 104 and the soldering pad 103 closest to the edge connecting line 104 being electrically connected to the same-polarity electrode; a first connecting portion 105 extending in the first direction X and electrically connected to the edge connecting line 104 and the soldering pad 103 closest to the edge connecting line 104; at least one opposite-polarity electrode located on a side of the first connecting portion 105 close to the central region 130 and disconnected by the soldering pad 103; and a second connecting portion 106 extending along the second direction Y and electrically connected to the opposite-polarity electrode disconnected by the soldering pad 103, at least one same-polarity electrode being disconnected by the second connecting portion 106; wherein the edge connecting line 104 includes two thickened portions 114 opposite along the second direction Y and a body portion 124 located between the two thickened portions 114, and the thickened portions 114 are electrically connected to the same-polarity electrode located in the border region 120 as well as the same-polarity electrode located in the central region 130 and disconnected by the second connecting portion 106; in the first direction X, a width of the thickened portion 114 is greater than a width of the body portion 124; one of the first finger 101 and the second finger 102 is the same-polarity electrode, and the other is the opposite-polarity electrode.

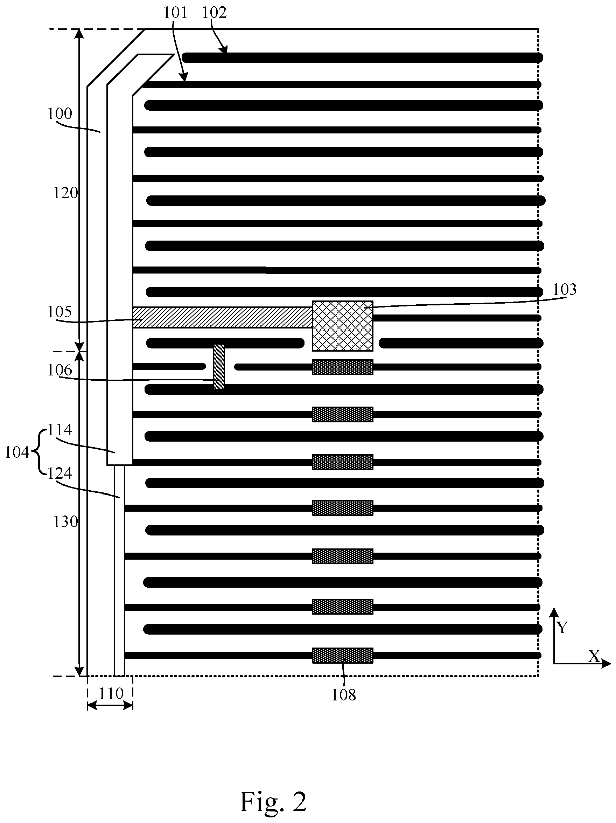

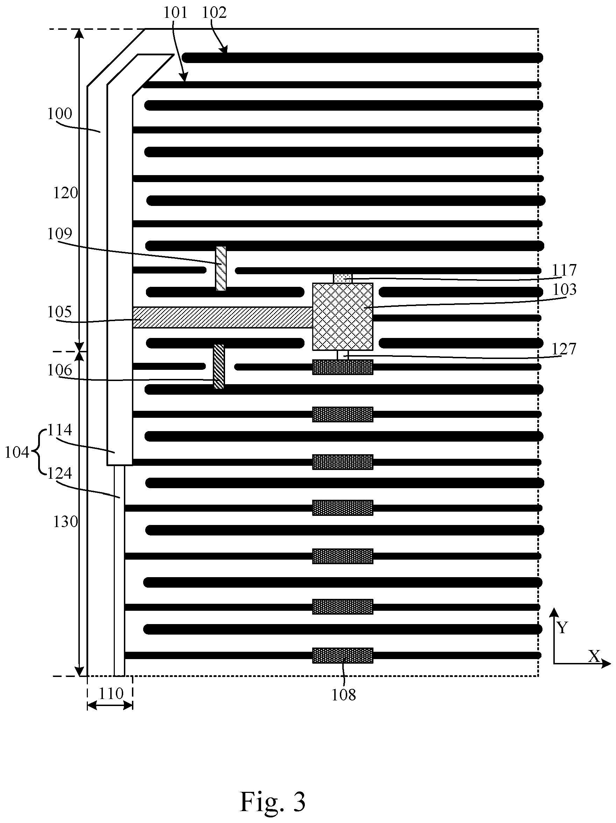

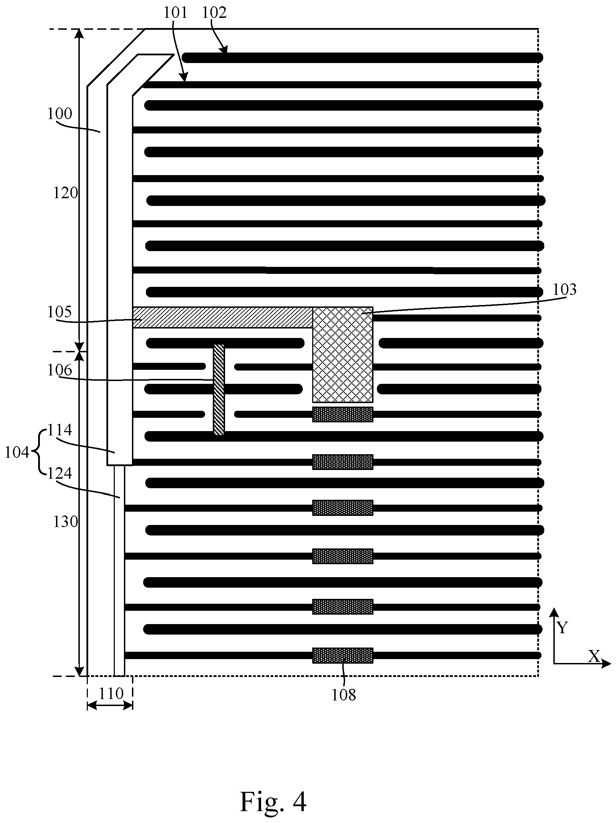

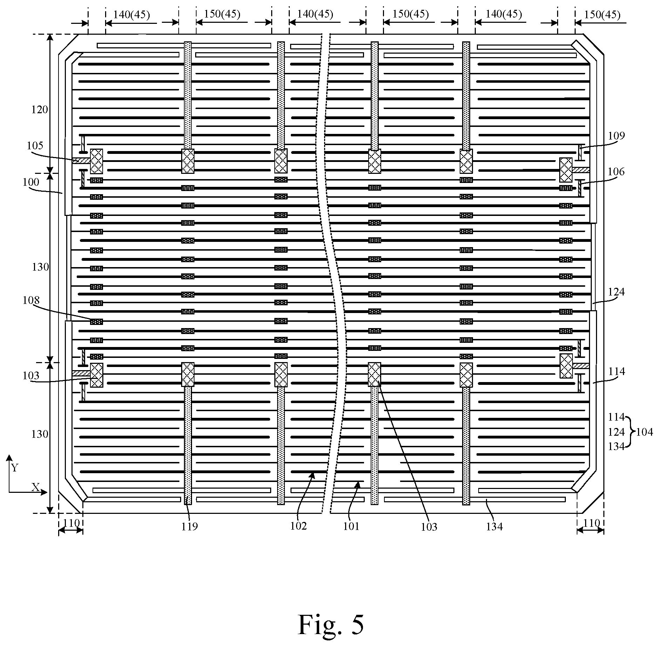

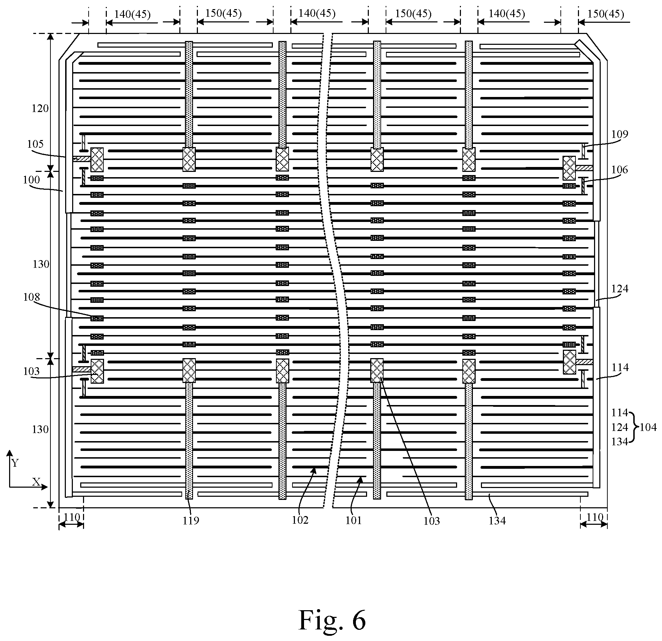

It should be noted that FIG. 1 is a first schematic partial enlarged top diagram of the back contact solar cell according to one or more embodiments of the present disclosure; FIG. 2 is a second schematic partial enlarged top diagram of the back contact solar cell according to one or more embodiments of the present disclosure; FIG. 3 is a third schematic partial enlarged top diagram of the back contact solar cell according to one or more embodiments of the present disclosure; FIG. 4 is a fourth schematic partial enlarged top diagram of the back contact solar cell according to one or more embodiments of the present disclosure; FIG. 5 is a schematic enlarged top diagram of the back contact solar cell according to one or more embodiments of the present disclosure; FIG. 6 is another schematic enlarged top diagram of the back contact solar cell according to one or more embodiments of the present disclosure.

Furthermore, first, in FIG. 1 to FIG. 6, the first finger 101 is indicated by a thin solid line, and the second finger 102 is indicated by a thick solid line.

Second, in FIG. 1 to FIG. 4, for one edge connecting line 104, as an example, the same-polarity electrode is the first finger 101, and the opposite-polarity electrode is the second finger 102. In practical applications, for one edge connecting line, the same-polarity electrode can be the second finger, and the opposite-polarity electrode can be the first finger. For example, referring to FIG. 5 or FIG. 6, along the first direction X, for the edge connecting line 104 on the left side, the same-polarity electrode is the first finger 101, and the opposite-polarity electrode is the second finger 102; for the edge connecting line 104 on the right side, the same-polarity electrode is the second finger 102, and the opposite-polarity electrode is the first finger 101.

Third, outlines of local regions of the back contact solar cell are indicated by dense dotted lines in FIG. 1 to FIG. 4, and in FIG. 5 and FIG. 6, the two sides of the back contact solar cell along the first direction X are indicated by cut-off wavy lines, and the cut-off wavy lines are drawn by dotted lines. FIG. 5 is different from FIG. 6 in that the back contact solar cell shown in FIG. 5 is a monolithic cell and the back contact solar cell shown in FIG. 6 is a half-cut cell.

It should be noted that one edge connecting line 104 is correspondingly arranged at least on one edge region 110, and for any edge connecting line 104, the finger connected to the edge connecting line 104 and the soldering pad 103 closest to the edge connecting line 104 has the same polarity. That is, the edge connecting line 104 and the soldering pad 103 closest to the edge connecting line 104 are electrically connected to the same-polarity electrode. In this way, when a solder strip electrically connected to the soldering pad 103 is subsequently arranged at the soldering pad 103, carriers in a part of the same-polarity electrode close to the edge region 110 can be transported to the solder strip by a region where the same-polarity electrode directly faces the solder strip, and the carriers can be transported to the edge connecting line 104 by an electrical connection between the same-polarity electrode and the edge connecting line 104, and then transported to the soldering pad through the first connecting portion 105 and the soldering pad 103 in sequence. In other words, even if the part of the same-polarity electrode directly facing the solder strip has a poor electrical connection, the carriers in the part of the same-polarity electrode close to the edge region 110 can be collected through the edge connecting line 104, the first connecting portion 105 and the soldering pad 103, thereby facilitating an improvement of the collection efficiency of the carriers in the back contact solar cell.

Moreover, by means of the design that the edge connecting line 104 and the soldering pad 103 closest to the edge connecting line 104 are electrically connected to the same-polarity electrode, circulation paths of the carriers in the same-polarity electrode can be increased, and the problem that the carriers cannot be effectively collected when the part of the same-polarity electrode directly facing the solder strip has a poor electrical connection is avoided, so that uniform circulation of the current in the back contact solar cell is favorably realized to improve the overall electrical performance of the back contact solar cell, for example, current density homogenization, thereby improving the uniformity of the overall photoelectric conversion efficiency of the back contact solar cell, so as to avoid the problem of local heating caused by the excessively large current difference of different regions in the back contact solar cell, and thus improve the hot spot resistance of the back contact solar cell.

Further, the thickened portion 114 of the edge connecting line 104 is designed to be electrically connected to the same-polarity electrode located in the border region 120 as well as the same-polarity electrode located in the central region 130 and disconnected by the second connecting portion 106. In other words, the thickened portion 114 of the edge connecting line 104 not only extends to a part connected to the first connecting portion 105, but also further extends close to the central region 130. That is, the thickened portion 114 of the edge connecting line 104 directly faces at least a partial region of the first connecting portion 105 along the first direction X. Therefore, on the basis of improving the transport efficiency of the carriers in the thickened portion 114 by means of the larger width of the thickened portion 114 in the first direction X, by means of the thickened portion 114 directly facing at least a partial region of the first connecting portion 105 in the first direction X, the efficiency of collecting, by the edge connecting line 104, the carriers in the same-polarity electrode disconnected by the second connecting portion 106 is favorably improved, for example, the transport resistance of the carriers in the same-polarity electrode disconnected by the second connecting portion 106 in the edge connecting line 104 is reduced to reduce the loss of the carriers in the same-polarity electrode disconnected by the second connecting portion 106 in the process that the carriers are transported to the solder strip by means of the edge connecting line 104, the first connecting portion 105 and the soldering pad 103, thereby facilitating a reduction of the difference between the density of the carriers in the same-polarity electrode disconnected by the second connecting portion 106 and the density of the carriers in the same-polarity electrodes in other regions, so as to further promote uniform circulation of the current in the back contact solar cell, and therefore further improve the overall electrical performance of the back contact solar cell.

It should be noted that the soldering pad 103 in the border region 120 can be regarded as a starting soldering joint (i.e., welding starting position) when the subsequent solder strip electrically contacts the back contact solar cell; the soldering pad 103 in the border region 120 can be regarded as a tail soldering joint (i.e., welding ending position) when the subsequent solder strip electrically contacts the photovoltaic cell.

In some cases, when the subsequent solder strip is electrically connected to the soldering pad 103, compared with acting forces applied by the solder strip to other regions in the back contact solar cell, the solder strip applies a greater acting force to the soldering pad 103 as the starting soldering joint or the tail soldering joint, and compared with the central region 130, the border region 120 is more susceptible to greater external forces. Based on this, the area of an orthographic projection of the soldering pad 103 as the starting soldering joint or the tail soldering joint on the cell substrate 100 is designed to be larger, so that the transport resistance of the soldering pad 103 can be reduced to facilitate an improvement of the efficiency of collecting the carriers by the soldering pad 103, the alignment precision and the connection strength between the subsequent solder strip and the soldering pad 103 can be improved, the problem of insufficient soldering or de-soldering caused by an excessively large acting force applied by the solder strip to the soldering pad 103 as the starting soldering joint or the tail soldering joint is avoided, the efficiency of collecting the carriers by the soldering pad 103 is also beneficially improved, and the connection stability between the subsequent solder strip and the soldering pad 103 is improved.

In addition, in view of the above considerations, the area of the orthographic projection of the soldering pad 103 on the cell substrate 100 is designed to be larger, and in order to ensure the arrangement density of the fingers on the cell substrate 100, at least one opposite-polarity electrode on the side of the first connecting portion 105 close to the central region 130 may be disconnected by the soldering pad 103, and therefore, the second connecting portion 106 needs to be designed to electrically connect the opposite-polarity electrode disconnected by the soldering pad 103 to another opposite-polarity electrode closest to the opposite-polarity electrode, so as to ensure collection of the carriers in the opposite-polarity electrode. Further, due to the design of the second connecting portion 106, at least one same-polarity electrode can be disconnected by the second connecting portion 106, so that the carriers need to be transported to the solder strip by the edge connecting line 104 at a part of the segmented same-polarity electrode close to the edge region 110, and therefore, a part of the edge connecting line 104 connected to the part of the segmented same-polarity electrode close to the edge region 110 is designed to be the thickened portion 114, which is beneficial to improving the efficiency of collecting, by the edge connecting line 104, the carriers in the same-polarity electrode disconnected by the second connecting portion 106, and therefore, the difference between the carrier density in the same-polarity electrode disconnected by the second connecting portion 106 and the carrier density in the same-polarity electrodes in other regions is reduced to further promote the uniform circulation of the current in the back contact solar cell, thereby further improving the overall electrical performance of the back contact solar cell.

The back contact solar cell according to embodiments of the present disclosure will be described in more detail below with reference to the accompanying drawings.

In some embodiments, referring to FIG. 2 to FIG. 6, the thickened portion 114 is electrically connected to a plurality of same-polarity electrodes on a side of the soldering pad 103 close to the central region 130. In other words, on the side of the first connecting portion 105 close to the central region 130, the thickened portion 114 is electrically connected to the same-polarity electrode disconnected by the second connecting portion 106 as well as other same-polarity electrodes adjacent to the same-polarity electrode disconnected by the second connecting portion 106, so that the thickened portion 114 can directly face the whole second connecting portion 106 along the first direction X. Therefore, an occupation ratio of the thickened portion 114 in the edge connecting line 104 is further increased favorably, that is, more parts in the edge connecting line 104 are formed by the thickened portion 114, so as to reduce the overall transport resistance of the edge connecting line 104 to improve the collection efficiency and the transport efficiency of the edge connecting line 104 for the same-polarity electrode and further promote the uniform circulation of the current in the back contact solar cell, thereby further improving the overall electrical performance of the back contact solar cell.

It should be noted that, in FIG. 2 to FIG. 6, as an example, the thickened portion 114 is connected to 3 same-polarity electrodes located on the side of the soldering pad 103 close to the central region 130, and the same-polarity electrode closest to the first connecting portion 105 is disconnected by the second connecting portion 106; in FIG. 1, as an example, the thickened portion 114 is connected to one same-polarity electrode located on the side of the soldering pad 103 close to the central region 130, and the same-polarity electrode is disconnected by the second connecting portion 106. In practical applications, the number of the same-polarity electrodes connected by the thickened portion and located on the side of the soldering pad close to the central region can be 2, 4, 5, or the like. The back contact solar cell according to embodiments of the present disclosure has no limitation on the number of the same-polarity electrodes connected by the thickened portion and located on the side of the soldering pad close to the central region as long as the thickened portion is connected to the same-polarity electrode disconnected by the second connecting portion.

In some cases, referring to FIG. 1, FIG. 2 or FIG. 3, on the side of the first connecting portion 105 close to the central region 130, the soldering pad 103 segments one opposite-polarity electrode, and the second connecting portion 106 segments one same-polarity electrode, so that the number of the same-polarity electrodes connected to the thickened portion 114 and disconnected by the second connecting portion 106 is at least 1; in some other cases, referring to FIG. 4, on the side of the first connecting portion 105 close to the central region 130, the soldering pad 103 segments 2 opposite-polarity electrodes, and the second connecting portion 106 needs to segment 2 adjacent same-polarity electrodes to collect the carriers in any segmented opposite-polarity electrode, so that the number of the same-polarity electrodes connected to the thickened portion 114 and disconnected by the second connecting portion 106 is at least 2.

It should be noted that, in practical applications, based on the difference in the area of the orthographic projection of the designed soldering pad on the cell substrate, on the side of the first connecting portion close to the central region, the number of the opposite-polarity electrodes disconnected by the soldering pad may be different, and in order to cause the second connecting portion to realize collection of the carriers in any segmented opposite-polarity electrode, the number of the same-polarity electrodes required to be disconnected by the second connecting portion may also be changed, and therefore, the length of extension of the thickened portion towards the central region may also be changed, so as to meet the requirement that the thickened portion may be connected to any same-polarity electrode disconnected by the second connecting portion.

In some cases, with continued reference to FIG. 1 to FIG. 6, the thickened portion 114 is located on the border region 120 as well as a part of the central region 130. In other words, the thickened portion 114 may extend further onto the central region 130.

In some embodiments, referring to FIG. 3, the back contact solar cell may further include: a first auxiliary line 117 electrically connected to the soldering pad 103 as well as at least one same-polarity electrode located on a side of the soldering pad 103 away from the central region 130; and a second auxiliary line 127 electrically connected to the soldering pad 103 as well as at least one same-polarity electrode located on a side of the soldering pad 103 close to the central region 130. In this way, the carriers in the same-polarity electrode connected to the first auxiliary line 117 can be transported to the soldering pad 103 through the first auxiliary line 117, and the carriers in the same-polarity electrode connected to the second auxiliary line 127 can be transported to the soldering pad 103 through the second auxiliary line 127. In other words, in the second direction Y, at least one same-polarity electrode located on both sides of the soldering pad 103 may be electrically connected to the soldering pad 103 through the first auxiliary line 117 or the second auxiliary line 127, and even if the part of the same-polarity electrode directly facing the solder strip is poorly electrically connected, the carriers in the part of the same-polarity electrode may be collected by the soldering pad 103 through the first auxiliary line 117 or the second auxiliary line 127, and further collected subsequently by the solder strip, so as to improve the collection efficiency of the carriers in the back contact solar cell.

It should be noted that, in general, more solder paste is needed when the subsequent solder strip is electrically connected (for example, welded) to the soldering pad 103 as the starting soldering joint or the tail soldering joint, so that a region in the solder strip directly facing the soldering pad 103 may be raised due to stacking of the solder paste, the same-polarity electrodes which are near the soldering pad 103 and are not in direct contact connection with the soldering pad 103 are greatly affected by the solder paste in the subsequent solder strip, the solder strip is not easily bent to be in contact connection with the same-polarity electrodes close to the soldering pad 103 in a short distance, and therefore, the problem of insufficient soldering or soldering missing between the solder strip and the same-polarity electrodes close to the soldering pad 103 is easily caused, and the problem of de-soldering between the solder strip and the same-polarity electrodes close to the soldering pad 103 is easily caused subsequently due to a large height of lowering of the solder strip in the short distance. Based on this, the first auxiliary line 117 and the second auxiliary line 127 are designed to directly electrically connect, onto the soldering pad 103, the same-polarity electrodes which easily generate the problems of insufficient soldering, soldering missing or de-soldering relative to the subsequent solder strip, so that even if the same-polarity electrodes close to the soldering pad 103 are in poor contact with the solder strip and cannot transport the current to the solder strip, the same-polarity electrodes can transport the carriers to the soldering pad 103 by means of the first auxiliary line 117 or the second auxiliary line 127, and then, the carriers are transported to the solder strip. In other words, the design of the first auxiliary line 117 and the second auxiliary line 127 is beneficial to further ensuring that the subsequent solder strip can collect the currents in all the first fingers 101 or all the second fingers 102, so as to further improve the photoelectric conversion efficiency of the photovoltaic cell.

In some cases, with combined reference to FIG. 3 and FIG. 5, or FIG. 3 and FIG. 6, the cell substrate 100 has first soldering regions 140 and second soldering regions 150 located between the two edge regions 110 and alternately arranged in the first direction X; the back contact solar cell may further include: a plurality of soldering joints 108 arranged between two adjacent soldering pads 103 at intervals along the second direction **Y,** one first finger 101 located on a region where the first soldering region 140 and the central region 130 coincide is electrically connected to one soldering joint 108, and one second finger 102 located on a region where the second soldering region 150 and the central region 130 coincide is electrically connected to one soldering joint 108.

It should be noted that the back contact solar cell may be a busbar-free back contact solar cell, and the solder strips may be arranged on both the first soldering region 140 and the second soldering region 150 subsequently. On the one hand, the solder strip is electrically connected to the soldering pad 103, so that the carriers in the same-polarity electrodes in contact connection with the soldering pad 103 can be collected by the solder strip through the soldering pad 103; moreover, the thickened portion 114 of the edge connecting line 104 is designed to be in contact connection with the same-polarity electrodes in the border region 120 as well as the same-polarity electrodes located in the central region 130 and disconnected by the second connecting portion 106, so that the carriers of the same-polarity electrodes in the border region 120 and the part of the same-polarity electrodes in the central region 130 can be collected by the solder strip through the edge connecting line 104 and the soldering pad 103 in sequence, so as to finally improve the efficiency of collecting the carriers in the back contact solar cell by the solder strip. On the other hand, the solder strip can also be electrically connected to the soldering joint 108 located in the central region 130, so that the carriers of the same-polarity electrodes located in the central region 130 can be directly collected by the solder strip through the soldering joint 108, and can also be collected by the solder strip after sequentially passing through the edge connecting line 104, the first connecting portion 105 and the soldering pad 103, which is beneficial to increasing the circulation paths of the carriers in the same-polarity electrodes, and avoiding the problem that the carriers cannot be effectively collected when the soldering joint 108 and the solder strip are poorly electrically connected, thereby facilitating realizing of the uniform circulation of the current in the back contact solar cell, so as to improve the overall electrical performance of the back contact solar cell, such as current density homogenization.

It should be noted that, in general, more solder paste is needed when the subsequent solder strip is electrically connected (for example, welded) to the soldering pad 103 as the starting soldering joint or the tail soldering joint, so that the region in the solder strip directly facing the soldering pad 103 may be raised due to stacking of the solder paste, the soldering joint 108 near the soldering pad 103 is most affected by the solder paste in the subsequent solder strip, the solder strip is not easily bent to be in contact connection with the soldering joint 108 close to the soldering pad 103 in a short distance, and therefore, the problem of insufficient soldering or soldering missing between the solder strip and the soldering joint 108 close to the soldering pad 103 is easily caused, and the problem of de-soldering between the solder strip and the soldering joint 108 close to the soldering pad 103 is easily caused subsequently due to a large height of lowering of the solder strip in the short distance. Based on this, the first auxiliary line 117 and the second auxiliary line 127 are designed to directly electrically connect, onto the soldering pad 103, the same-polarity electrodes corresponding to the soldering joints 108 which easily generate the problems of insufficient soldering, soldering missing or de-soldering relative to the subsequent solder strip, so that even if the soldering joint 108 close to the soldering pad 103 is in poor contact with the solder strip and cannot transmit the current in the same-polarity electrode corresponding to the soldering joint 108 to the solder strip, the same-polarity electrode corresponding to the soldering joint 108 can directly transmit the current to the soldering pad 103 by means of the first auxiliary line 117 or the second auxiliary line 127, and then, the carriers are transported to the solder strip.

In addition, the first auxiliary line 117 and the second auxiliary line 127 have limited extension lengths in the second direction Y, and are not located on the entire length of the central region 130 in the second direction Y, and the soldering joint 108 that is not in contact connection with the first auxiliary line 117 or the second auxiliary line 127 is farther from the soldering pad 103 in the first direction X, so that even if the region in the solder strip directly facing the soldering pad 103 is raised due to the stacking of the solder paste, the solder strip is prone to be bent in a long distance to be in contact connection with the soldering joint 108 farther from the soldering pad 103, and an excessively large welding acting force is not applied to the soldering joint 108 farther from the soldering pad 103, thereby effectively avoiding the problem of insufficient soldering/de-soldering between the soldering joint 108 farther from the soldering pad 103 and the solder strip, so as to ensure the connection stability between the soldering joint 108 farther from the soldering pad 103 and the solder strip. Moreover, after the region in the solder strip directly facing the soldering pad 103 is raised due to the stacking of the solder paste, the solder strip may bend downwards to contact the soldering joint 108 farther from the soldering pad 103 due to its own gravity over a longer extension length.

In some examples, referring to FIG. 3, the number of the first auxiliary lines 117 in contact connection with the same soldering pad 103 may be only 1, which is beneficial to reducing the quantity of raw materials required to prepare the first auxiliary line 117, thereby reducing the preparation cost of the photovoltaic cell. In some other examples, the number of the first auxiliary lines in contact connection with the same soldering pad 103 may be multiple, and the multiple first auxiliary lines are in contact connection with at least one soldering joint close to the soldering pad.

In some examples, with continued reference to FIG. 3, the number of the second auxiliary lines 127 in contact connection with the same soldering pad 103 may be only 1, which is beneficial to reducing the quantity of raw materials required to prepare the second auxiliary line 127, thereby reducing the preparation cost of the photovoltaic cell. In some other examples, the number of the second auxiliary lines in contact connection with the same soldering pad 103 may be multiple, and the multiple second auxiliary lines are in contact connection with at least one soldering joint close to the soldering pad.

In some examples, referring to FIG. 5 or FIG. 6, along the second direction Y, one second finger 102 is arranged between two adjacent soldering joints 108 located in the same first soldering region 140; and along the second direction Y, one first finger 101 is arranged between two adjacent soldering joints 108 located in the same second soldering region 150.

It should be noted that the photovoltaic cell is a busbar-free back contact solar cell, and a single soldering joint 108 can be in contact connection with a single electrode 101. If one soldering joint 108 is in contact connection with the first finger 101, one second finger 102 is arranged between the soldering joint 108 and another soldering joint 108 adjacent to the soldering joint 108 along the second direction Y for spacing; if one soldering joint 108 is in contact connection with the second finger 102, one first finger 101 is arranged between the soldering joint 108 and another soldering joint 108 adjacent to the soldering joint 108 along the second direction Y for spacing. In other words, the first finger 101 and the second finger 102 in the central region 130 are single segments extending along the first direction X, and when the subsequent solder strip is electrically connected to the soldering joint 108, the subsequent solder strip is insulated from the opposite-polarity electrode between the adjacent soldering joints 108. In this way, it is beneficial to enabling more regions on the central region 130 to be used to arrange the first finger 101 and the second finger 102, so that there are more transport paths for the carriers in the cell substrate 100, and based on the double assurances that the solder strip collects the carriers on the same-polarity electrode by the soldering joint 108 and the solder strip collects the carriers on the same-polarity electrode by the edge connecting line 104, the circulation paths of the carriers in the same-polarity electrode are enriched, and the uniform circulation of the current in the back contact solar cell is further promoted, so as to improve the overall electrical performance of the back contact solar cell, such as current density homogenization, and improve the hot spot resistance of the back contact solar cell.

In some examples, with continued reference to FIG. 5 or FIG. 6, of the first and second fingers 101 and 102 located on the border region 120, the first finger 101 is segmented on at least some second soldering regions 150, and the second finger 102 is segmented on at least some first soldering regions 140; of the first and second fingers 101 and 102 located on the central region 130, a part of the first finger 101 located on the first soldering region 140 is provided with the soldering joint 108, the first finger 101 is not segmented on the second soldering region 150, a part of the second finger 102 located on the second soldering region 150 is provided with the soldering joint 108, and the second finger 102 is not segmented on the first soldering region 140.

In other words, each of the first finger 101 and the second finger 102 on the border region 120 includes multiple segments disconnected along the first direction X, and the first finger 101 and the second finger 102 in the central region 130 are both single segments extending along the first direction X.

In some cases, referring to FIG. 3, the width of the first auxiliary line 117 may be greater than that of the second auxiliary line 127 in the first direction X.

It should be noted that regions of the border region 120 closer to upper and lower edges of the cell substrate 100 in the second direction Y are more easily subjected to larger external forces. In this way, when the first auxiliary line 117 is located on the side of the soldering pad 103 away from the central region 130 and the second auxiliary line 127 is located on the side of the soldering pad 103 near the central region 130, the first auxiliary line 117 is closer to the upper and lower edges of the cell substrate 100 than the second auxiliary line 127 along the second direction Y, and the first auxiliary line 117 is more easily subjected to a larger external force. On this basis, the width of the first auxiliary line 117 is designed to be larger than that of the second auxiliary line 127 along the first direction X, which is beneficial to increasing the connection area between the first auxiliary line 117 and the soldering pad 103 and increasing the connection area between the first auxiliary line 117 and the same-polarity electrode or soldering joint 108 by means of the first auxiliary line 117 with the larger width, so as to reduce the probability of poor contact, such as disconnected contact, between the first auxiliary line 117 and the soldering pad 103 or the same-polarity electrode or soldering joint 108 after a larger external force is applied, thereby ensuring the connection stability between the first auxiliary line 117 and the soldering pad 103 or the same-polarity electrode or soldering joint 108.

In some embodiments, referring to FIG. 1 to FIG. 6, the width of the first connecting portion 105 may be greater than that of the same-polarity electrode along the second direction Y. In other words, the width of the first connecting portion 105 may be greater than that of the same-polarity electrode in contact connection with the soldering pad 103 in the second direction Y.

It should be noted that compared with the carriers collected on the same-polarity electrodes in contact connection with the soldering pad 103, the carriers on the plurality of same-polarity electrodes connected to the edge connecting line 104 are collected on the first connecting portion 105, so that the density of the carriers collected on the first connecting portion 105 is greater. Based on this, by designing the width of the first connecting portion 105 to be larger than that of the same-polarity electrode, the sectional area of the first connecting portion 105 is larger, the transport resistance of the first connecting portion is smaller, and the density of the carriers collected in the edge connecting line 104 is matched better, which is beneficial to improving the efficiency of transmission of the current by the first connecting portion 105, thereby further improving the photoelectric conversion efficiency of the back contact solar cell.

Moreover, the large sectional area of the first connecting portion 105 is beneficial to increasing the contact area of a contact position of the first connecting portion 105 and the edge connecting line 104, and increasing the contact area of a contact position of the first connecting portion 105 and the soldering pad 103, thereby improving the connection strength of the first connecting portion 105 and the edge connecting line 104, and the connection strength of the first connecting portion 105 and the soldering pad 103, so as to ensure the stability of the electrical connection between the edge connecting line 104 and the soldering pad 103.

In some embodiments, referring to FIG. 3, FIG. 5 or FIG. 6, at least one opposite-polarity electrode on a side of the first connecting portion 105 away from the central region 130 is disconnected by the soldering pad 103; the back contact solar cell may further include: a third connecting portion 109 extending along the second direction Y and electrically connected to the opposite-polarity electrode disconnected by the soldering pad 103 and located on the side of the first connecting portion 105 away from the central region 130, at least one same-polarity electrode being disconnected by the third connecting portion 109.

It should be noted that the number of the opposite-polarity electrodes disconnected by the soldering pad 103 may vary based on the difference of the area of the orthographic projection of the soldering pad 103 on the cell substrate 100, the soldering pad 103 has a first side near the central region 130 and a second side away from the central region 130, and the soldering pad 103 may segment the same-polarity electrode on the second side in addition to the first side. Based on this, the third connecting portion 109 is designed to collect the carriers in the opposite-polarity electrode disconnected by the soldering pad 103 and located on the side of the first connecting portion 105 away from the central region 130, and the carriers are further transported to another opposite-polarity electrode that is not disconnected by means of the third connecting portion 109, so as to further ensure the collection of the carriers in the opposite-polarity electrode.

In some embodiments, referring to FIG. 5 or FIG. 6, the cell substrate 100 has a plurality of soldering regions 45 located between the two edge regions 110 and spaced apart along the first direction X; the back contact solar cell may further include: a bus portion 119 located on an overlapped region of some soldering regions 45 and the border region 120, the bus portion 119 is electrically connected to a plurality of same-polarity electrodes located on the side of the soldering pad 103 away from the central region 130, and the soldering region 45 with the bus portion 119 is spaced apart from the edge region 110 by at least one soldering region 45.

In other words, in the first direction X, the bus portion 119 is not present on the soldering region 45 closest to the edge region 110, the first finger 101 and the second finger 102 are not segmented on the soldering region 45 closest to the edge region 110, the carriers of one of the first finger 101 and the second finger 102 are collected by the edge connecting line 104, and the carriers of the other are collected by the bus portion 119 on the soldering region 45 next-closest to the edge region 110.

In this way, the plurality of same-polarity fingers which are located on the border region 120 and not in contact connection with the soldering pad 103 can be in contact connection with the bus portion 119, so that the bus portion 119 can collect the currents in the plural same-polarity fingers which are located on the border region 120 and not in contact connection with the soldering pad 103, and finally transmit the current to the soldering pad 103.

In some cases, with combined reference to FIG. 5 to FIG. 7, FIG. 7 is a schematic top diagram of a combination of the soldering pad and the bus portion in the back contact solar cell according to one or more embodiments of the present disclosure, at least one bus portion 119 may include a first end portion close to the soldering pad 103 and a second end portion away from the soldering pad 103, and the width of the first end portion is greater than that of the second end portion along the first direction X.

On the one hand, since more solder paste is needed when the subsequent solder strip is electrically connected (for example, welded) to the soldering pad 103 as the starting soldering joint or the tail soldering joint, molten solder paste more easily exists in the vicinity of the soldering pad 103. Therefore, in the bus portion 119, the first end portion closer to the soldering pad 103 is more likely to come into contact with the molten solder paste than the second end portion away from the soldering pad 103, thereby causing a breakage problem. Based on this, the width of the first end portion is designed to be greater than that of the second end portion along the first direction X, which helps to reduce the risk that the first end portion is broken due to the influence of the molten solder paste based on the wider first end portion, so as to improve the structural stability of the bus portion 119.

On the other hand, the regions of the border region 120 closer to the upper and lower edges of the cell substrate 100 in the second direction Y are more easily subjected to larger external forces. Based on this, the width of the first end portion is designed to be greater than that of the second end portion along the first direction X, which is beneficial to increasing the area of contact between the first end portion and the soldering pad 103 to improve the connection strength between the first end portion and the soldering pad 103, so as to reduce the risk that the first end portion is disconnected from the soldering pad 103 due to a large external force.

In another aspect, the bus portion 119 may collect the carriers in the plurality of same-polarity electrodes that are located on the border region 120 and not in contact connection with the soldering pad 103, and in a direction to the central region 130 from the border region 120, the number of the same-polarity electrodes electrically connected to the bus portion 119 is gradually increased, and the current collected in the bus portion 119 is gradually increased, so that the design of the larger width of the first end portion is beneficial to reducing the transport resistance of the first end portion and the contact area between the first end portion and the soldering pad 103, and thus reduces the transport resistance on a path through which the current is transmitted from the bus portion 119 to the soldering pad 103 in many ways, so as to improve the current collection capability of the bus portion 119 to match the plurality of same-polarity electrodes, thereby reducing the risk of overheating caused by more current collection at the first end portion of the bus portion 119 to improve the electrical performance and yield of the back contact solar cell.

In addition, the design that different parts of the bus portion 119 along the second direction Y have different widths in the first direction X is beneficial to reasonably reducing the quantity of raw materials required for preparing the bus portion 119, thereby reducing the preparation cost of the back contact solar cell.

In some cases, with continued reference to FIG. 5 to FIG. 7, along the direction from the border region 120 to the central region 130, the width of at least one bus portion 119 in the first direction X is gradually increased, so that the transport resistance of the bus portion 119 is gradually decreased, which facilitates the bus portion to collect more carriers in the same-polarity electrodes on the way, so as to improve the carrier collection capability of the bus portion 119.

It should be noted that a plurality of bus portions 119 are designed in a single back contact solar cell, the variation of the widths of different parts of any bus portion 119 in the second direction Y in the first direction X can be adjusted according to actual requirements, and in the first direction X, the width of the first end portion of any bus portion 119 is designed to be greater than that of the second end portion, which can improve the structural stability of the bus portion 119, improve the current collection capability of the bus portion 119, and improve the connection strength between the first end portion and the soldering pad 103 to reduce the risk of disconnection between the first end portion and the soldering pad 103.

In some cases, referring to FIG. 5 or FIG. 6, the number of the same-polarity electrodes in contact connection with a single bus portion 119 may be greater than the number of the same-polarity electrodes in contact connection with a single soldering pad 103. In this way, under the condition that the distance between any two adjacent same-polarity electrodes along the second direction Y is substantially consistent, the soldering pad 103 can be prompted to be located on a region in the border region 120 close to the central region 130, and the soldering pad 103 can be prevented from being too close to the upper and lower edges of the cell substrate 100, so as to prevent the upper and lower edges of the cell substrate 100 from being damaged when the subsequent solder strip is in contact connection with the soldering pad 103.

In some cases, referring to FIG. 5 or FIG. 6, the edge connecting line 104 may further include: a border portion 134 located in the border region 120 and extending along the second direction **Y,** one end of the border portion 134 is electrically connected to one end of the thickened portion 114, and the body portion 124 is electrically connected to the other end of the thickened portion 114; the border portion 134 is in contact connection with the bus portion 119 electrically connected to one of the first finger 101 and the second finger 102, and is disconnected at the bus portion 119 electrically connected to the other of the first finger 101 and the second finger 102.

In some examples, the border portion 134 may be prepared together with the same-polarity electrode in the edge connector line 104. In other words, both the border portion 134 and the same-polarity electrode may be embedded in a passivation layer of the cell substrate 100 to be in contact connection with a doped layer in the cell substrate 100, so as to directly collect the carriers in the cell substrate 100 to create a denser current collection network. In addition, both the thickened portion 114 and the body portion 124 may be located on a surface of the passivation layer of the cell substrate 100.

In some cases, referring to FIG. 6, when the single back contact solar cell is a half-cut cell, the single half-cut cell has a chamfered end on one side of one border region 120, and has a right-angle end on one side of the other border region 120. In order to match the chamfered design of the half-cut cell, one end of the thickened portion 114 near the chamfered end is bent towards a center of the half-cut cell in the first direction X. In other words, the thickened portion 114 near the chamfered end includes a first part extending in the second direction Y and a second part extending obliquely relative to the first direction X. In contrast, the thickened portion 114 near the right-angle end may have an elongated structure extending in the second direction Y.

It should be noted that, when the single back contact solar cell is a half-cut cell, along the second direction, the right-angle ends of two adjacent half-cut cells may be arranged adjacently, or the right-angle end of one of the two adjacent half-cut cells is arranged adjacently to the chamfered end of the other half-cut cell. In conclusion, the edge connecting line 104 and the soldering pad 103 closest to the edge connecting line 104 are electrically connected to the same-polarity electrode, so that even if the part of the same-polarity electrode directly facing the solder strip has a poor electrical connection, the carriers in the part of the same-polarity electrode close to the edge region 110 can be collected through the edge connecting line 104, the first connecting portion 105 and the soldering pad 103, thereby facilitating an improvement of the collection efficiency of the carriers in the back contact solar cell. In addition, the edge connecting line 104 can increase circulation paths of the carriers in the same-polarity electrode, and promote uniform circulation of the current in the back contact solar cell to improve the overall electrical performance of the back contact solar cell, such as current density homogenization, thereby improving the hot spot resistance of the back contact solar cell.

Further, the thickened portion 114 of the edge connecting line 104 is designed to be electrically connected to the same-polarity electrode located in the border region 120 as well as the same-polarity electrode located in the central region 130 and disconnected by the second connecting portion 106. In other words, the thickened portion 114 of the edge connecting line 104 not only extends to a part connected to the first connecting portion 105, but also further extends close to the central region 130. Therefore, on the basis of improving the transport efficiency of the carriers in the thickened portion 114 by means of the larger width of the thickened portion 114 in the first direction X, by means of the thickened portion 114 directly facing at least a partial region of the first connecting portion 105 in the first direction X, the efficiency of collecting, by the edge connecting line 104, the carriers in the same-polarity electrode disconnected by the second connecting portion 106 is favorably improved, for example, the loss of the carriers in the same-polarity electrode disconnected by the second connecting portion 106 is reduced in the process that the carriers are transported to the solder strip by means of the edge connecting line 104, the first connecting portion 105 and the soldering pad 103, thereby facilitating a reduction of the difference between the density of the carriers in the same-polarity electrode disconnected by the second connecting portion 106 and the density of the carriers in the same-polarity electrodes in other regions, so as to further promote uniform circulation of the current in the back contact solar cell, and therefore further improve the overall electrical performance of the back contact solar cell.

Embodiments of the present disclosure provide a back contact tandem solar cell, including the back contact solar cell according to the foregoing embodiments. The back contact tandem solar cell according to embodiments of the present disclosure will be described in detail below with reference to the accompanying drawings. It should be noted that the same or corresponding parts as those in the previous embodiments are not repeated herein.

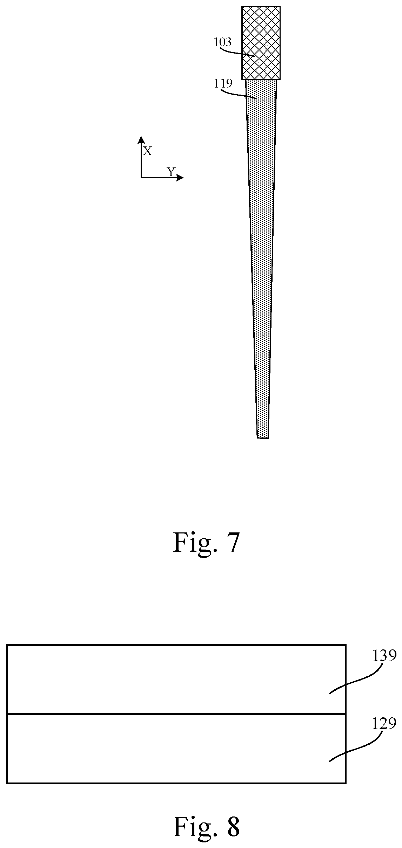

Referring to FIG. 8, FIG. 8 is a schematic partial sectional diagram of the back contact tandem solar cell according to one or more embodiments of the present disclosure, and the tandem solar cell includes: a bottom cell 129 which is the back contact solar cell according to the previous embodiments; and a top cell 139 located on one side of the bottom cell 129.

In some embodiments, the top cell 139 is one of a perovskite solar cell, a donor-acceptor cell, a cadmium telluride (CdTe) solar cell, a copper indium gallium selenide (CIGS) solar cell or a gallium arsenide (GaAs) solar cell.

In some cases, the top cell 139 may include: a first transport layer, a perovskite base, a second transport layer, a transparent conductive layer and an antireflection layer which are stacked. The first transport layer directly faces the bottom cell 129.

In some examples, the first transport layer may be one of an electron transport layer and a hole transport layer, and the second transport layer may be the other of the electron transport layer and the hole transport layer.

In some embodiments, a band gap width of the top cell 139 may be larger than that of the bottom cell 129, so that the back contact tandem solar cell can have a wider spectral response range by stacking the top cell 139 above the bottom cell 129, thereby utilizing solar energy to the maximum extent and improving the efficiency of the back contact tandem solar cell.

In some embodiments, the back contact tandem solar cell may further include: an intermediate connection layer (not shown) connected between the bottom cell 129 and the top cell 139.

In some cases, the intermediate connection layer is typically a tunnel junction or a quite thin metal or transparent electrode composite layer. In some embodiments, the intermediate connection layer may be made of a transparent conductive oxide having good optoelectronic characteristics, high photon permeability, and high electrical conductivity, thereby enabling the top cell 139 and the bottom cell 129 to maintain good ohmic contact.

In some other cases, the electrodes in the back contact solar cell as the bottom cell 129 may serve as the intermediate connection layer for electrical connection with the top cell 139.

In some embodiments, the cell substrate 100 in the back contact solar cell as the bottom cell 129 has opposite front and back surfaces, the top cell 139 may be on a side of the front surface away from the back surface, or may be on a side of the back surface away from the front surface.

Embodiments of the present disclosure provide a photovoltaic module formed by connecting a plurality of back contact solar cells according to the foregoing embodiments. The photovoltaic module according to embodiments of the present disclosure will be described below with reference to the accompanying drawings. It should be noted that the same or corresponding parts as those in the previous embodiments are not repeated herein.

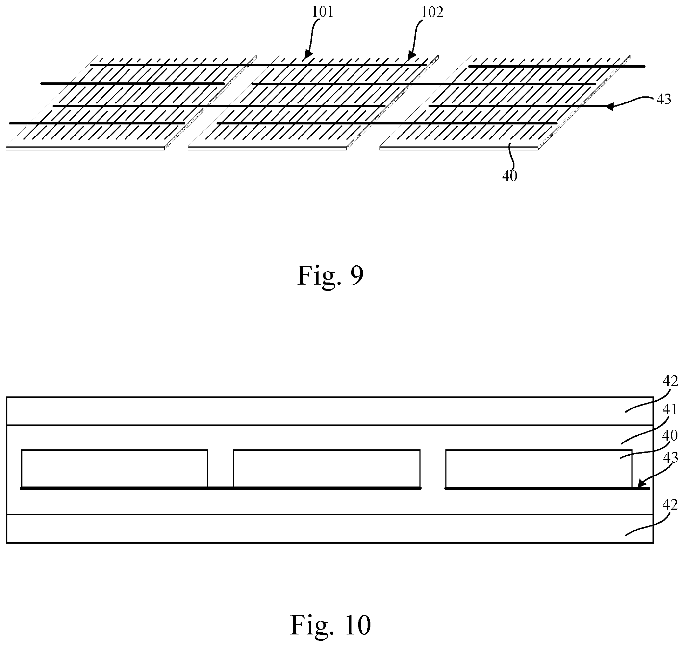

With combined reference to FIG. 9, FIG. 10 and FIG. 1 to FIG. 8, the photovoltaic module includes: a solar cell string formed by connecting a plurality of back contact solar cells 40 according to the foregoing embodiments or by connecting a plurality of back contact tandem solar cells according to the foregoing embodiments; a encapsulation adhesive film 41 for covering a surface of the solar cell string; and a cover plate 42 for covering a surface of the encapsulation adhesive film 41 away from the solar cell string.

FIG. 9 is a schematic partial perspective diagram of the solar cell string in the photovoltaic module according to one or more embodiments of the present disclosure; and FIG. 10 is a schematic partial sectional diagram of the photovoltaic module according to one or more embodiments of the present disclosure.

In some embodiments, the back contact solar cell 40 is a BC solar cell, and the BC solar cell includes, but is not limited to, an interdigitated back contact (IBC) solar cell, a heterojunction back contact (HBC) solar cell, a TOPCon back contact (TBC) solar cell, a hybrid passivated back contact (HPBC) solar cell, or the like. Furthermore, the back contact solar cells 40 are electrically connected in a monolithic or plural-segment form to form the plurality of solar cell strings, and the plurality of solar cell strings are electrically connected in series and/or in parallel. The back contact solar cell 40 may be a monolithic cell or a segmented cell, and a segmented cell refers to a solar cell formed by cutting a complete monolithic cell.

In some embodiments, referring to FIG. 9 or FIG. 10, the plural back contact solar cells 40 may be electrically connected by conductive strips 43. FIG. 9 and FIG. 10 only illustrate one positional relationship between the back contact solar cells 40, and in practical applications, the electrodes of plural adjacent back contact solar cells may also be located on different sides, and the conductive strip connects different sides of two adjacent back contact solar cells.

In some embodiments, the encapsulation adhesive film 41 includes a first packaging layer covering one of the front and back surfaces of the back contact solar cell 40 and a second packaging layer covering the other of the front and back surfaces of the back contact solar cell 40. In some embodiments, at least one of the first packaging layer and the second packaging layer may be an organic encapsulation adhesive film, such as a polyvinyl butyral (PVB) adhesive film, an ethylene vinyl acetate (EVA) adhesive film, a polyolyaltha olfin (POE) adhesive film, a polyethylene terephthalate (PET) adhesive film, or the like. Or, at least one of the first packaging layer and the second packaging layer may be an EP adhesive film, an EPE adhesive film, a PVP adhesive film, or the like. The EP adhesive film refers to a co-extrusion adhesive film formed by an EVA adhesive film and a POE adhesive film which are stacked, the **EPE** adhesive film refers to a co-extrusion adhesive film formed by an EVA adhesive film, a POE adhesive film and an EVA adhesive film which are stacked in sequence, and the PVP adhesive film refers to a co-extrusion adhesive film formed by a POE adhesive film, an EVA adhesive film and a POE adhesive film which are stacked. The co-extrusion adhesive film may be prepared by sequentially extruding one or more raw materials onto another prepared adhesive film or bonding different types of prepared adhesive films together during processing of the adhesive film.

In some cases, the first packaging layer and the second packaging layer have a boundary before lamination, and the concept of the first packaging layer and the second packaging layer does not exist after lamination. That is, the first packaging layer and the second packaging layer form the integral encapsulation adhesive film 41.

In some embodiments, the cover plate 42 may be a glass cover plate, a plastic cover plate, or the like, having a light transmitting function. In some embodiments, a surface of the cover plate 42 facing the encapsulation adhesive film 41 may be a concave-convex surface or a textured surface including a plurality of convex structures, so as to increase the utilization rate of incident light. The cover plate 42 includes a first cover plate opposite to the first packaging layer and a second cover plate opposite to the second packaging layer.

In some cases, a surface of the back contact solar cell 40 has a plurality of fingers spaced apart along the second direction, and the conductive strip 43 is electrically connected to the plurality of fingers on each of every two adjacent back contact solar cells 40 during the process of constructing the solar cell string by using the back contact solar cells 40.

## Claims

1. A back contact solar cell, comprising:
a cell substrate, wherein the cell substrate has two edge regions opposite to each other along a first direction, two border regions opposite to each other along a second direction, and a central region located between the two border regions;
first fingers and second fingers, wherein the first fingers and second fingers are alternately arranged along the second direction on the cell substrate;
soldering pads located in the border region, wherein each soldering pad of the soldering joints is electrically connected to at least one same-polarity electrode;
an edge connecting line at least located at the edge region, wherein the edge connecting line and the soldering pad closest to the edge connecting line are electrically connected to a same-polarity electrode of the at least one same-polarity electrode;
a first connecting portion extending in the first direction and electrically connected to the edge connecting line and the soldering pad closest to the edge connecting line;
at least one opposite-polarity electrode located on a side of the first connecting portion close to the central region and disconnected by the soldering pad; and
a second connecting portion extending along the second direction and electrically connected to the opposite-polarity electrode disconnected by the soldering pad, wherein at least one same-polarity electrode is disconnected by the second connecting portion;
wherein the edge connecting line comprises two thickened portions opposite to each other along the second direction and a body portion located between the two thickened portions, and the thickened portions are electrically connected to the same-polarity electrode located in the border region and also connected to a same-polarity electrode located in the central region and disconnected by the second connecting portion; in the first direction, a width of the thickened portion is greater than a width of the body portion;
the first fingers and the second fingers are respectively the same-polarity electrodes and opposite-polarity electrodes.

2. The back contact solar cell according to claim 1, further comprising:
a first auxiliary line electrically connected to the soldering pad as well as at least one same-polarity electrode located on a side of the soldering pad away from the central region.

3. The back contact solar cell according to claim 2, further comprising a second auxiliary line electrically connected to the soldering pad as well as at least one same-polarity electrode located on a side of the soldering pad close to the central region.

4. The back contact solar cell according to claim 2, wherein a width of the first auxiliary line is greater than a width of the second auxiliary line along the first direction.

5. The back contact solar cell according to claim 2, wherein the cell substrate has first soldering regions and second soldering regions located between the two edge regions and alternately arranged in the first direction;
wherein the back contact solar cell further comprises: soldering joints arranged and spaced apart between two adjacent soldering pads along the second direction, one first finger of the first fingers located on a region where the first soldering region overlaps with the central region is electrically connected to one soldering joint, and one second finger of the second fingers located on a region where the second soldering region overlaps with the central region is electrically connected to one soldering joint.

6. The back contact solar cell according to claim 5, wherein along the second direction, one second finger is provided between two adjacent soldering joints located in a same first soldering region; and
along the second direction, one first finger is provided between two adjacent soldering joints located in a same second soldering region.

7. The back contact solar cell according to claim 1, wherein a width of the first connecting portion is greater than a width of the same-polarity electrode along the second direction.

8. The back contact solar cell according to claim 1, wherein at least one opposite-polarity electrode on a side of the first connecting portion facing away from the central region is disconnected by the soldering pad;
wherein the back contact solar cell further comprises: a third connecting portion extending along the second direction and electrically connected to the opposite-polarity electrode disconnected by the soldering pad and located on the side of the first connecting portion away facing from the central region, and
at least one same-polarity electrode is disconnected by the third connecting portion.

9. The back contact solar cell according to claim 1, wherein the cell substrate has soldering regions located between the two edge regions and spaced apart along the first direction.

10. The back contact solar cell according to claim 9, wherein the back contact solar cell further comprises: a bus portion located on an overlapped region of some soldering regions and the border region, the bus portion is electrically connected to a plurality of same-polarity electrodes located on the side of the soldering pad away from the central region; and
the soldering region with the bus portion is spaced apart from the edge region by at least one soldering region.

11. The back contact solar cell according to claim 10, wherein at least one bus portion comprises a first end portion close to the soldering pad and a second end portion away from the soldering pad, and a width of the first end portion is greater than a width of the second end portion along the first direction X.

12. The back contact solar cell according to claim 10, wherein along a direction from the border region to the central region, a width of at least one bus portion in the first direction X is gradually increased.

13. The back contact solar cell according to claim 1, wherein the edge connecting line further comprises: a border portion located in a border region of the two border regions and extending along the second direction, an end of the border portion is electrically connected to one end of the thickened portion, and the body portion is electrically connected to the other end of the thickened portion;
wherein the border portion is in contact connection with the bus portion electrically connected to one of a first finger of the first fingers and a second finger of the second fingers, and is disconnected at a bus portion electrically connected to the other of the first finger and the second finger.

14. A back contact tandem solar cell, comprising:
a bottom cell which is the back contact solar cell according to claim 1; and
a top cell located on a side of the bottom cell.

15. A photovoltaic module, comprising:
a solar cell string formed by connecting back contact solar cells according to any of claims 1-14;
an encapsulation adhesive film for covering a surface of the solar cell string; and
a cover plate for covering a surface of the encapsulation adhesive film facing away from the solar cell string.
